# EUROPÄISCHE PATENTSCHRIFT

(11) **EP 2 766 698 B1**
(45) Veröffentlichungstag und Bekanntmachung des Hinweises auf die Patenterteilung: **05.08.2015**
(21) Anmeldenummer: 12784469.4
(22) Anmeldetag: 08.10.2012
(51) Int. Cl.: G01D 18/00, G01R 31/28, H01L 21/66

(54) **SENSOREINHEIT UND VERFAHREN ZUR BANDENDEPROGRAMMIERUNG EINER SENSOREINHEIT**
SENSOR UNIT AND METHOD FOR THE END OF LINE PROGRAMMING OF A SENSOR UNIT
MODULE DE CAPTEUR ET PROCÉDÉ DE PROGRAMMATION DE FIN DE BANDE D'UN MODULE DE CAPTEUR

(30) Priorität: 11.10.2011 DE 102011084283
(43) Veröffentlichungstag der Anmeldung: 20.08.2014
(73) Patentinhaber: Robert Bosch GmbH, 70442 Stuttgart (DE)
(72) Erfinder: SCHUERMANN, Marcus, 70806 Kornwestheim (DE); SCHRUELLKAMP, Michael, 74379 Ingersheim (DE)
(86) Internationale Anmeldenummer: PCT/EP2012/069822
(87) Internationale Veröffentlichungsnummer: WO 2013/053662

(56) Entgegenhaltungen:
- EP-A1- 0 892 439
- EP-A2- 1 970 720
- US-A- 5 895 942
- US-A1- 2008 157 076
- US-B1- 6 252 503

## Beschreibung

### Stand der Technik

Die Erfindung geht aus von einer Sensoreinheit nach der Gattung des unabhängigen Patentanspruchs 1 und von einem Verfahren zur Bandendeprogrammierung einer Sensoreinheit nach der Gattung des unabhängigen Patentanspruchs 9.

Ein Sensor misst eine physikalische Größe und übermittelt diese beispielsweise an eine zentrale Recheneinheit bzw. eine Regelungseinheit. Bei den bekannten Sensoren können Testschaltungen bzw. Testleitungen, wie beispielsweise Power-down-Leitungen für ein gezieltes Abschalten von Schaltungsblöcken, auf der ASIC-Fläche für den Testbetrieb eingesetzt werden, um eine hohe Testabdeckung der Sensoren zu erreichen. Diese Testschaltungen bzw. Testleitungen werden allein zum Zweck des Testens des ASICs (Application-Specific Integrated Circuit; Anwendungsspezifische Integrierte Schaltung) während des Fertigungsprozess des Sensors, beim Vormessen und/oder beim Endmessen aktiviert. Im Normalbetrieb des Sensors in der Applikation bleiben diese Testschaltungen/Testleitungen deaktiviert. Um die Sensoren beim Vormessen und/oder Endmessen auf ihre Soll-Parameter, wie beispielsweise Empfindlichkeit, Messbereich, Oszillatorabgleich usw., zu programmieren, können beispielsweise beim Vormessen Programmierpads auf ASIC-Level oder beim Endmessen im verpackten Zustand Programmierpins verwendet werden. Außerdem können zusätzliche Mess-Pads zur Eingabe von Digitalpattern usw. beim Vormessen zum Testen des ASICs verwendet werden.

In der Offenlegungsschrift DE 103 32 512 A1 wird beispielsweise eine Vorrichtung zum Beaufschlagen eines elektrischen Bauteils beschrieben. Die beschriebene Vorrichtung beaufschlagt das elektrische Bauteil mit mindestens einem eine dauerhafte Veränderung der elektrischen Eigenschaften des Bauteils herbeiführenden Energieimpuls. Die Vorrichtung umfasst mindestens ein den Energieimpuls leitendes elektrisches Leistungsschaltelement, das als Hochvolt-MOS-Transistor ausgeführt ist. Die beschriebene Vorrichtung kann beispielsweise zur Bandendeprogrammierung eines Produkts verwendet werden. Die Bandendeprogrammierung wird am Ende des Produktherstellungsprozesses dazu verwendet, um Produkten, welche in gleicher Weise hergestellt wurden, individuelle Merkmale zu verleihen. Dafür wird im Produkt mindestens ein Bauteil vorgesehen, welches während des Fertigungsprozesses zunächst bei allen Produkten gleich ausgebildet ist, dann aber am sogenannten Bandende, d.h. im letzten Fertigungsschritt, eine besondere Behandlung zur Einprägung von individuellen Merkmalen erfährt. So ist es beispielsweise bekannt, dass im Produkt Dioden vorgesehen werden, die mittels Beaufschlagung durch einen Energieimpuls in ihren elektrischen Eigenschaften verändert werden können. Durch eine im Produkt integrierte Detektionsvorrichtungen können solche Änderung der elektrischen Eigenschaften zu einem späteren Zeitpunkt festgestellt werden und mittels den von der Detektionsvorrichtung ermittelten Daten können dann bestimmte Merkmale oder Funktionen aktiviert bzw. deaktiviert werden oder aber zum Beispiel eine Seriennummer ausgegeben werden.

Aus der US 2008/0157076 A1 ist eine Halbleiterschaltung mit Testanschlüssen und einer Anschlussvorrichtung bekannt, welche die Testanschlüsse während einer Testbetriebsart elektrisch mit einer integrierten Schaltung der Halbleiterschaltung verbindet.

Aus der EP 1 970 720 A2 sind ein Halbleiterbauelement und ein Verfahren zum Testen eines solchen Halbleiterbauelements bekannt. Das Halbleiterbauelement weist auf einem Halbleiterchip mindestens ein Sensorelement zum Messen einer physikalischen Größe und eine Auswerteeinrichtung auf. Das Halbleiterbauelement ist zwischen einer ersten und zweiten Betriebsart umschaltbar. In einer ersten Betriebsart ist das Sensorelement für die zu messende physikalische Größe empfindlich und ein Messsignalausgang des Sensorelements ist mit einem Eingangsanschluss der Auswerteeinrichtung verbunden. In der zweiten Betriebsart ist das Sensorelement für die zu messende physikalische Größe unempfindlich und/oder der Signalpfad zwischen dem Messsignalausgang und dem Eingangsanschluss ist unterbrochen. Auf dem Halbleiterchip ist eine Testsignalquelle zur Erzeugung eines das Messsignal des Sensorelements simulierendes Testsignal angeordnet. Die Testsignalquelle ist in der zweiten Betriebsart mit dem Eingangsanschluss der Auswerteeinrichtung verbunden oder verbindbar.

### Offenbarung der Erfindung

Die erfindungsgemäße Sensoreinheit mit den Merkmalen des unabhängigen Patentanspruchs 1 und das erfindungsgemäße Verfahren zur Bandendeprogrammierung einer Sensoreinheit haben demgegenüber den Vorteil, dass eine breitbandige Entstörung von EMV-empfindlichen Testanschlusskontakten (EMV: elektromagnetische Verträglichkeit), welche Programmierpads, Programmierpins, Testpads, Testpins usw. umfassen können, über ein gezieltes Abschalten der im Normalbetrieb der Sensoreinheit nicht mehr erforderlichen Testanschlusskontakte ermöglicht wird. Hierdurch kann die Koppelstruktur abgetrennt werden, über welche die EMV-Störungen in die Sensoreinheit gelangen können. Des Weiteren können Ausführungsformen der vorliegenden Erfindung den Testblock vom Funktionsblock trennen und dadurch die Fehlerzahlen während der Sensorproduktion reduzieren. Zudem wird die Verbindung des Testblocks physikalisch von der funktionellen Fläche der Sensoreinheit entkoppelt, so dass der Testblock auch im Fehlerfall zu keinen Störungen bzw. Fehlern der Sensoreinheit beitragen kann. Durch das gezielte Trennen der in Frage kommenden Testblöcke vom Funktionsblock, kann die Komplexität der Sensoreinheit reduziert und dadurch auch die Gesamtwahrscheinlichkeit für einen Sensorfehler reduziert werden.

Das Abschalten und/oder Trennen kann durch eine Bandendeprogrammierung am Ende der Sensorfertigung durchgeführt werden, wenn die Sensoreinheit vollständig programmiert und abgeglichen ist. Die Sensoreinheit ist vorzugsweise als ASIC ausgeführt. Das Abschalten und/oder Trennen kann dann über auf der ASIC-Fläche angeordnete Transistorlogikschaltungen realisiert werden.

Ausführungsformen der vorliegenden Erfindung stellen eine Sensoreinheit mit mindestens einem Funktionsblock und mindestens einem Testblock zum Testen des mindestens einen Funktionsblocks zur Verfügung. Es ist ein Schaltblock mit mindestens einem Schaltelement vorgesehen, welcher am Ende des Fertigungsprozesses mindestens einen Testanschlusskontakt, welcher im Normalbetrieb der Sensoreinheit nicht erforderlich ist, vom Testblock trennt und/oder mindestens eine Testverbindung zwischen dem Testblock und dem Funktionsblock auftrennt.

Erfindungsgemäß schließt der Schaltblock am Ende des Fertigungsprozesses den mindestens einen Testblock mit einem Bezugspotential kurz. Dadurch kann die EMV-Anfälligkeit der Sensoreinheit weiter reduziert werden. Hierbei ist darauf zu achten, dass die entstehende Schleife in Bezug auf die Fläche klein bleibt, da sich sonst eine neue Koppelstruktur ausbilden kann. Der mindestens eine Testblock kann beispielsweise zum Versorgungsspannungspotential oder zum Massepotential kurz geschlossen werden. Diese Maßnahme wird zusätzlich zur Trennung des mindestens einen Testanschlusskontakts vom Testblock durchgeführt, da das alleinige Kurzschließen des Testblocks mit einem Bezugspotential eher ungünstig ist, da sich EMV-Störungen von außen auf das Versorgungsspannungspotential oder das Massepotential der Sensoreinheit einkoppeln lassen und andere Funktionsblöcke der Sensoreinheit gestört werden können.

Des Weiteren wird ein Verfahren zur Bandendeprogrammierung einer Sensoreinheit vorgeschlagen, welche mindestens einen Funktionsblock und mindestens einen Testblock zum Testen des mindestens einen Funktionsblocks aufweist. Hierbei wird am Ende des Fertigungsprozesses ein Testanschlusskontakt, welcher im Normalbetrieb der Sensoreinheit nicht erforderlich ist, vom Testblock getrennt. Zusätzlich oder alternativ kann mindestens eine Testverbindung zwischen dem Testblock und dem Funktionsblock aufgetrennt werden.

Erfindungsgemäß schließt der Schaltblock am Ende des Fertigungsprozesses den mindestens einen Testblock mit einem Bezugspotential kurz.

Ausführungsformen der vorliegenden Erfindung können flächenneutral und damit kostenneutral in die Sensoreinheit implementiert werden, da sie im Digitalteil realisiert werden können. Außerdem sind Ausführungsformen der vorliegenden Erfindung nicht toleranzbehaftet, unterliegen keinen Lebensdauereffekten und sind von außen nicht manipulierbar.

Durch die in den abhängigen Ansprüchen aufgeführten Maßnahmen und Weiterbildungen sind vorteilhafte Verbesserungen der im unabhängigen Patentanspruch 1 angegebenen Sensoreinheit und des im unabhängigen Patentanspruch 9 angegebenen Verfahrens zur Bandendeprogrammierung einer Sensoreinheit möglich.

In vorteilhafter Ausgestaltung der erfindungsgemäßen Sensoreinheit kann der Testblock beispielsweise eine Testschaltung und/oder eine Testlogik und/oder den mindestens einen Testanschlusskontakt umfassen. Hierbei kann die Testschaltung über die mindestens eine Testverbindung mit dem Funktionsblock und über mindestens eine Anschlussverbindung mit dem mindestens einen Testanschlusskontakt verbunden werden. Die Testlogik kann Ansteuersignale für die Testschaltung zum Testen und/oder Programmieren des Funktionsblocks erzeugen, wobei über den mindestens einen Testanschlusskontakt Signale zum Testen des Funktionsblocks eingegeben werden können.

In weiterer vorteilhafter Ausgestaltung der erfindungsgemäßen Sensoreinheit kann der Schaltblock eine Schaltsteuerlogik zum Ansteuern des mindestens einen Schaltelements umfassen. Die Schaltsteuerlogik und die Testlogik können als gemeinsame Teststeuerlogik ausgeführt werden, wodurch der Flächenbedarf weiter reduziert werden kann.

In weiterer vorteilhafter Ausgestaltung der erfindungsgemäßen Sensoreinheit ist das mindestens eine Schaltelement beispielsweise als Öffner zum Auftrennen einer korrespondierenden bestehenden Signalverbindung oder als Schließer zum Herstellen einer Signalverbindung ausgeführt.

In weiterer vorteilhafter Ausgestaltung der erfindungsgemäßen Sensoreinheit ist das mindestens eine Schaltelement zum Auftrennen der mindestens einen Testverbindung zwischen dem Testblock und dem Funktionsblock im direkten Umfeld des Funktionsblocks angeordnet. Dadurch kann eine optimale Abschaltung ermöglicht und potentielle Angriffspunkte für Fehler bzw. Defekte können reduziert werden.

Ausführungsbeispiele der Erfindung sind in den Zeichnungen dargestellt und werden in der nachfolgenden Beschreibung näher erläutert. In den Zeichnungen bezeichnen gleiche Bezugszeichen Komponenten bzw. Elemente, die gleiche bzw. analoge Funktionen ausführen.

Kurze Beschreibung der Zeichnungen
Fig. 1 zeigt ein schematisches Blockdiagramm eines ersten Ausführungsbeispiels einer erfindungsgemäßen Sensoreinheit.
Fig. 2 zeigt ein schematisches Blockdiagramm eines zweiten Ausführungsbeispiels einer erfindungsgemäßen Sensoreinheit.
Fig. 3 zeigt ein schematisches Blockdiagramm eines dritten Ausführungsbeispiels einer erfindungsgemäßen Sensoreinheit.
Fig. 4 zeigt ein schematisches Blockdiagramm eines vierten Ausführungsbeispiels einer erfindungsgemäßen Sensoreinheit.
Fig. 5 zeigt ein schematisches Blockdiagramm eines fünften Ausführungsbeispiels einer erfindungsgemäßen Sensoreinheit.

Bei den bekannten Sensoren werden die nach außen geführten Test- bzw. Programmierpads in der Applikation für ein EMV-robustes Design entweder über eine auf dem ASIC ausgeführte Kapazität oder eine auf der Leiterplatte ausgeführte Kapazität oder direkt (niederohmig) auf ein bestimmtes Potential (meist Masse) gelegt oder offen gelassen. Die internen Test- und Programmierpads werden bei den bekannten Sensoren standardmäßig nicht befiltert oder terminiert.

Durch das Vorhandensein der Testschaltungen bzw. Testleitungen steigt auch die Wahrscheinlichkeit von Qualitätsauffälligkeiten im Normalbetrieb des Sensors in der Applikation. Treten in diesen Testschaltungen bzw. Testleitungen Fehler bzw. Defekte auf, kann es zu einer Fehlfunktion des Sensors kommen. So können beispielsweise auch statistische ASIC-Fehler in Testschaltungen bzw. Testleitungen zu einem Sensordefekt führen, welcher als Qualitätsrückläufer in die Bandstatistik bzw. Feldstatistik eingeht.

Das Fehlen der internen Befilterung bzw. von Terminierungen an Test- und Programmierpads kann zu EMV-Auffälligkeiten bei den Sensoren führen. ASIC interne Kapazitäten für die Befilterung der nach außen geführten Test- bzw. Programmierpads weisen den Nachteil auf, dass sie nicht flächenneutral und damit

nicht kostenneutral sind. Zudem sind der internen Befilterung Grenzen in Bezug auf die maximale Fläche und damit der maximalen Kapazität gesetzt. Außerdem ist die Wirksamkeit der Kapazitäten über den Frequenzbereich begrenzt, d.h. die Kapazitäten sind bei bestimmten Frequenzen mehr oder weniger wirksam. Externe Entstörmaßnahmen über Kapazitäten sind möglich, aufgrund von Kosten und Platzbedarf auf der Leiterplatte jedoch nicht praktikabel. Außerdem kann sich die Bondinduktivität negativ auf die Wirksamkeit des Filters bzw. der Terminierung auswirken.

### Ausführungsformen der Erfindung

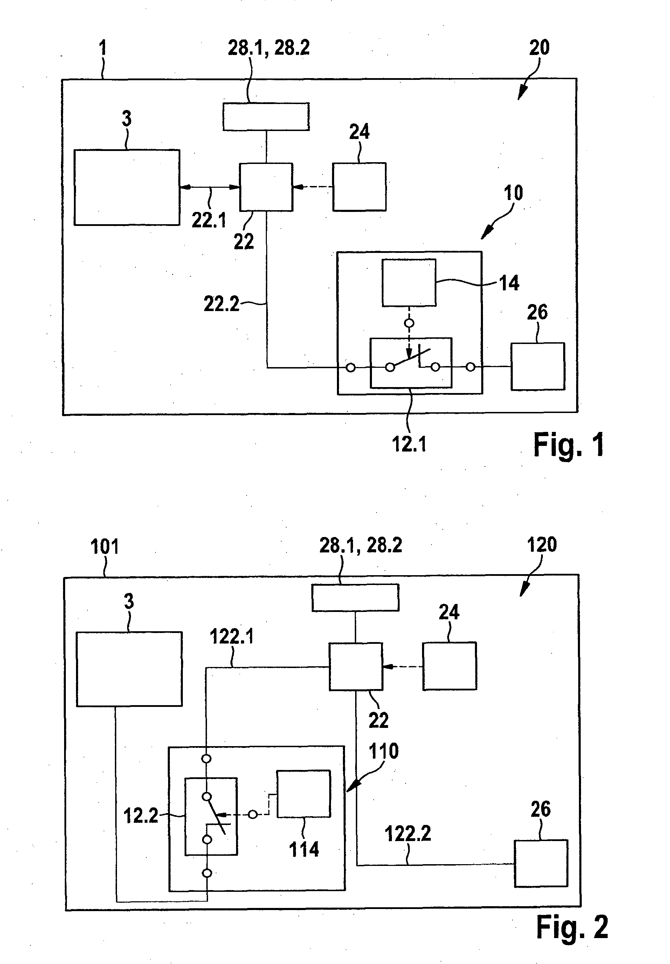

Wie aus Fig. 1 bis 5 ersichtlich ist, umfassen Ausführungsbeispiele einer erfindungsgemäßen Sensoreinheit 1, 101, 201, 301, 401 mindestens einen Funktionsblock 3.

Erfindungsgemäß ist ein Schaltblock 10, 110, 210, 310, 410 mit mindestens einem Schaltelement 12.1, 12.2, 12.3 vorgesehen, welcher am Ende des Fertigungsprozesses mindestens einen Testanschlusskontakt 26, welcher im Normalbetrieb der Sensoreinheit 1, 101, 201, 301, 401 nicht erforderlich ist, vom Testblock 20, 220, 320, 420 trennt und/oder mindestens eine Testverbindung 122.1 zwischen dem Testblock 120, 220, 420 und dem Funktionsblock 3 auftrennt.

In den dargestellten Ausführungsbeispielen ist die Sensoreinheit 1, 101, 201, 301, 401 jeweils als ASIC (Application-Specific Integrated Circuit; Anwendungsspezifische Integrierte Schaltung) ausgeführt. Daher ist der jeweilige Schaltblock 10, 110, 210, 310, 410 mit den Schaltelementen 12.1, 12.2, 12.3 vorzugsweise als Transistorlogikschaltung auf dem ASIC realisiert. Dadurch ist der zusätzliche Schaltblock 10, 110, 210, 310, 410 flächenneutral und damit kostenneutral, da er im Digitalteil realisiert werden kann. Zudem ist der jeweilige Schaltblock 10, 110, 210, 310, 410 nicht toleranzbehaftet, unterliegt keinen Lebensdauereffekten und ist von außen nicht manipulierbar.

Wie aus Fig. 1 bis 5 weiter ersichtlich ist, umfasst der Testblock 20, 120, 220, 320, 420 in den dargestellten Ausführungsbeispielen jeweils eine Testschaltung 22, eine Testlogik 24 und den mindestens einen Testanschlusskontakt 26. Die Testschaltung 22 ist über die mindestens eine Testverbindung 22.1, 122.1 mit dem Funktionsblock 3 und über mindestens eine Anschlussverbindung 22.2, 122.2 mit dem mindestens einen Testanschlusskontakt 26 verbunden. Die Testlogik 24 erzeugt Ansteuersignale für die Testschaltung 22 zum Testen des Funktionsblocks 3. Über den mindestens einen Testanschlusskontakt 26 können Signale zum Testen des Funktionsblocks 3 eingegeben werden.

Wie aus Fig. 1 bis 5 weiter ersichtlich ist, umfasst der Schaltblock 10, 110, 210, 310, 410 in den dargestellten Ausführungsbeispielen jeweils eine Schaltsteuerlogik 14, 114, 214, 314, 414 zum Ansteuern des mindestens einen Schaltelements 12.1, 12.2, 12.3. Bei einem alternativen nicht dargestellten Ausführungsbeispiel der erfindungsgemäßen Sensoreinheit 1, 101, 201, 301, 401 sind die Schaltsteuerlogik 14, 114, 214, 314, 414 und die Testlogik 24 als gemeinsame Teststeuerlogik ausgeführt.

Wie aus Fig. 1 weiter ersichtlich ist, umfasst der Schaltblock 10 des Testblocks 20 im dargestellten ersten Ausführungsbeispiel der Sensoreinheit 1 eine Schaltsteuerlogik 14 und ein als Öffner ausgeführtes erstes Schaltelement 12.1, welches in die Anschlussverbindung 22.2 zwischen dem dargestellten Testanschlusskontakt 26 und der Testschaltung 22 eingeschleift ist. Die Testschaltung 22 ist über die Testverbindung 22.1 direkt mit dem Funktionsblock 3 der als ASIC ausgeführten Sensoreinheit 1 verbunden. Des Weiteren wird die Testschaltung 22 mit einem Versorgungsspannungspotential 28.1 und einem Massepotential 28.2 versorgt und von der Testlogik 24 angesteuert. Durch das erste Schaltelement 12.1 wird nach der Programmierung die Anschlussverbindung 22.2 aufgetrennt und der Testanschlusskontakt 26 weggeschaltet, welcher intern angeordnet oder über einen Bond nach außen geführt ist. Dadurch ist die Koppelstruktur abgetrennt, über welche EMV-Störungen in die als ASIC ausgeführte Sensoreinheit 1 gelangen können.

Wie aus Fig. 2 weiter ersichtlich ist, umfasst der Schaltblock 110 des Testblocks 120 im dargestellten zwei Ausführungsbeispiel der Sensoreinheit 101 eine Schaltsteuerlogik 114 und ein als Öffner ausgeführtes zweites Schaltelement 12.2, welches in die Testverbindung 122.1 zwischen der Testschaltung 22 und dem Funktionsblock 3 der als ASIC ausgeführten Sensoreinheit 101 eingeschleift ist. Der dargestellte Testanschlusskontakt 26 ist über die Anschlussverbindung 22.2 direkt mit der Testschaltung 22 verbunden. Des Weiteren wird die Testschaltung 22 mit einem Versorgungsspannungspotential 28.1 und einem Massepotential 28.2 versorgt und von der Testlogik 24 angesteuert. Durch das zweite Schaltelement 12.2 wird nach der Programmierung die Testschaltung 22 vom Funktionsblock 3 weggeschaltet. Dadurch ist die Testverbindung 122.1 der Testschaltung physikalisch vom Funktionsblock 3 auf der funktionellen ASIC-Fläche der Sensoreinheit 101 entkoppelt und kann, auch im Fehlerfall, zu keinen Störungen bzw. Fehlern der Sensoreinheit 101 mehr beitragen. Für eine optimale Abschaltung kann das zweite Schaltelement 12.2 im ASIC Layout so dicht wie möglich an die funktionale ASIC-Fläche platziert werden, um potentielle Angriffspunkte für Fehler bzw. Defekte zu reduzieren.

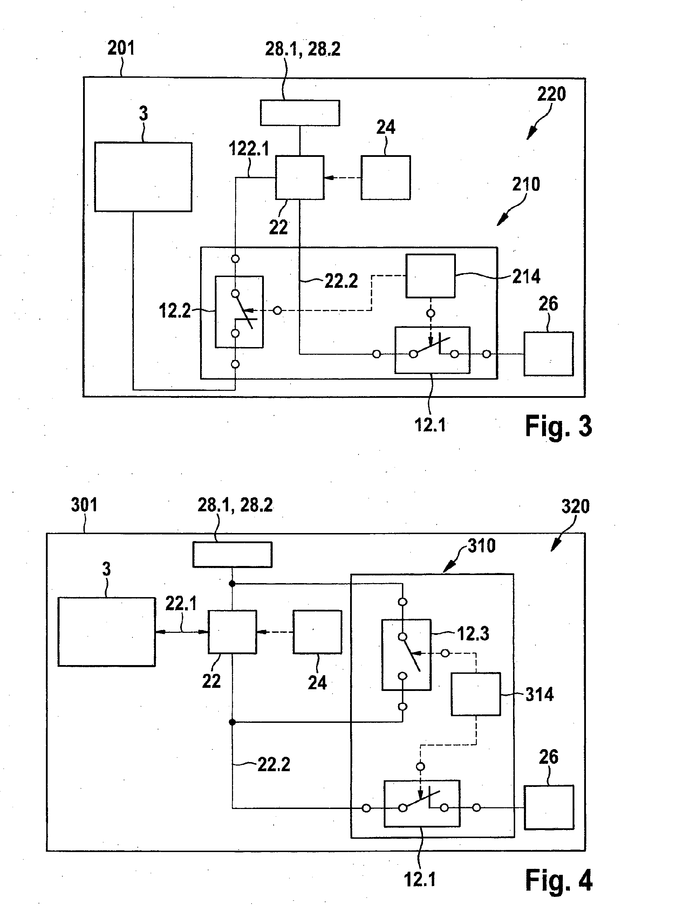

Wie aus Fig. 3 weiter ersichtlich ist, umfasst der Schaltblock 210 des Testblocks 220 im dargestellten dritten Ausführungsbeispiel der Sensoreinheit 201 eine Schaltsteuerlogik 214, das als Öffner ausgeführte erste Schaltelement 12.1, welches in die Anschlussverbindung 22.2 zwischen dem dargestellten Testanschlusskontakt 26 und der Testschaltung 22 eingeschleift ist, und das als Öffner ausgeführte zweite Schaltelement 12.2, welches in die Testverbindung 122.1 zwischen der Testschaltung 22 und dem Funktionsblock 3 der als ASIC ausgeführten Sensoreinheit 201 eingeschleift ist. Des Weiteren wird die Testschaltung 22 mit einem Versorgungsspannungspotential 28.1 und einem Massepotential 28.2 versorgt und von der Testlogik 24 angesteuert. Durch das erste Schaltelement 12.1 wird nach der Programmierung die Anschlussverbindung 22.2 aufgetrennt und der Testanschlusskontakt 26 weggeschaltet. Dadurch ist die Koppelstruktur abgetrennt, über welche EMV-Störungen in die als ASIC ausgeführte Sensoreinheit 1 gelangen können. Zusätzlich wird durch das zweite Schaltelement 12.2 nach der Programmierung die Testschaltung 22 vom Funktionsblock 3 weggeschaltet. Dadurch ist die Testverbindung 122.1 der Testschaltung physikalisch vom Funktionsblock 3 auf der funktionellen ASIC-Fläche der Sensoreinheit 201 entkoppelt und kann, auch im Fehlerfall, zu keinen Störungen bzw. Fehlern der Sensoreinheit 201 mehr beitragen. Für eine optimale Abschaltung kann das zweite Schaltelement 12.2 im ASIC Layout so dicht wie möglich an die funktionale ASIC-Fläche platziert werden, um potentielle Angriffspunkte für Fehler bzw. Defekte zu reduzieren.

Wie aus Fig. 4 weiter ersichtlich ist, umfasst der Schaltblock 310 des Testblocks 320 im dargestellten vierten Ausführungsbeispiel der Sensoreinheit 301 eine Schaltsteuerlogik 314, ein als Öffner ausgeführtes erstes Schaltelement 12.1, welches in die Anschlussverbindung 22.2 zwischen dem dargestellten Testanschlusskontakt 26 und der Testschaltung 22 eingeschleift ist, und ein als Schließer ausgeführtes drittes Schaltelement 12.3, über welches die Testschaltung 22 des Testblocks 320 mit einem Bezugspotential 28.1, 28.2 kurzgeschlossen werden kann. Die Testschaltung 22 ist über die Testverbindung 22.1 direkt mit dem Funktionsblock 3 der als ASIC ausgeführten Sensoreinheit 301 verbunden. Des Weiteren wird die Testschaltung 22 mit einem Versorgungsspannungspotential 28.1 und einem Massepotential 28.2 versorgt und von der Testlogik 24 angesteuert. Durch das erste Schaltelement 12.1 wird nach der Programmierung die Anschlussverbindung 22.2 aufgetrennt und der Testanschlusskontakt 26 weggeschaltet, welcher intern angeordnet oder über einen Bond nach außen geführt ist. Dadurch ist die Koppelstruktur abgetrennt, über welche EMV-Störungen in die als ASIC ausgeführte Sensoreinheit 1 gelangen können. Zusätzlich schließt das dritte Schaltelement 12.3 am Ende des Fertigungsprozesses die Testschaltung 22 des Testblocks 320 mit einem Bezugspotential 28.1, 28.2 kurz. Hierbei kann der Kurzschluss entweder zum Versorgungsspannungspotential 28.1 oder zum Massepotential 28.2 erfolgen. Dadurch kann die EMV-Anfälligkeit der Sensoreinheit 301 weiter reduziert werden.

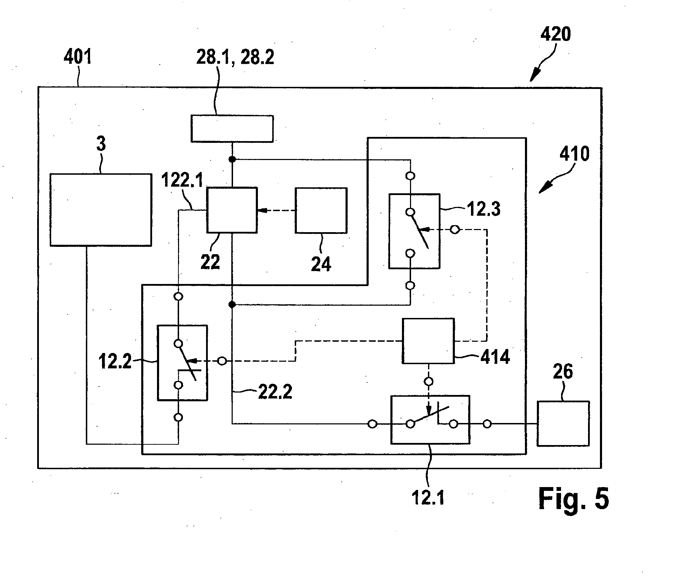

Wie aus Fig. 5 weiter ersichtlich ist, umfasst der Schaltblock 410 des Testblocks 420 im dargestellten fünften Ausführungsbeispiel der Sensoreinheit 401 eine Schaltsteuerlogik 414, das als Öffner ausgeführte erste Schaltelement 12.1, welches in die Anschlussverbindung 22.2 zwischen dem dargestellten Testanschlusskontakt 26 und der Testschaltung 22 eingeschleift ist, das als Öffner ausgeführte zweite Schaltelement 12.2, welches in die Testverbindung 122.1 zwischen der Testschaltung 22 und dem Funktionsblock 3 der als ASIC ausgeführten Sensoreinheit 201 eingeschleift ist, und das als Schließer ausgeführte dritte Schaltelement 12.3, über welches die Testschaltung 22 des Testblocks 420 mit einem Bezugspotential 28.1, 28.2 kurzgeschlossen werden kann. Des Weiteren wird die Testschaltung 22 mit einem Versorgungsspannungspotential 28.1 und einem Massepotential 28.2 versorgt und von der Testlogik 24 angesteuert. Durch das erste Schaltelement 12.1 wird nach der Programmierung die Anschlussverbindung 22.2 aufgetrennt und der Testanschlusskontakt 26 weggeschaltet. Dadurch ist die Koppelstruktur abgetrennt, über welche EMV-Störungen in die als ASIC ausgeführte Sensoreinheit 1 gelangen können. Zusätzlich schließt das dritte Schaltelement 12.3 am Ende des Fertigungsprozesses die Testschaltung 22 des Testblocks 320 mit einem Bezugspotential 28.1, 28.2 kurz. Hierbei kann der Kurzschluss entweder zum Versorgungsspannungspotential 28.1 oder zum Massepotential 28.2 erfolgen. Dadurch kann die EMV-Anfälligkeit der Sensoreinheit 401 weiter reduziert werden. Des Weiteren wird durch das zweite Schaltelement 12.2 nach der Programmierung die Testschaltung 22 vom Funktionsblock 3 weggeschaltet. Dadurch ist die Testverbindung 122.1 der Testschaltung 22 physikalisch vom Funktionsblock 3 auf der funktionellen ASIC-Fläche der Sensoreinheit 401 entkoppelt und kann, auch im Fehlerfall, zu keinen Störungen bzw. Fehlem der Sensoreinheit 401 mehr beitragen. Für eine optimale Abschaltung kann das zweite Schaltelement 12.2 im ASIC Layout so dicht wie möglich an die funktionale ASIC-Fläche platziert werden, um potentielle Angriffspunkte für Fehler bzw. Defekte zu reduzieren.

Ausführungsformen der vorliegenden Erfindung ermöglichen in vorteilhafter Weise eine breitbandige Entstörung der EMV-empfindlichen Testanschlusskontakte über ein gezieltes Abschalten der im Normalbetrieb der Sensoreinheit nicht mehr erforderlichen Testanschlusskontakte. Des Weiteren können Ausführungsformen der vorliegenden Erfindung durch das gezielte Trennen der in Frage kommenden Testblöcke vom Funktionsblock die Komplexität der Sensoreinheit reduzieren und dadurch auch die Gesamtwahrscheinlichkeit für einen Sensorfehler reduzieren.

## Patentansprüche

1. Sensoreinheit mit mindestens einem Funktionsblock (3) und mindestens einem Testblock (20, 120, 220, 320, 420) zum Testen des mindestens einen Funktionsblocks (3) und einem Schaltblock (10, 110, 210, 310, 410) mit mindestens einem Schaltelement (12.1, 12.2, 12.3), welcher mindestens eine Testverbindung (122.1) zwischen dem Testblock (120, 220, 420) und dem Funktionsblock (3) auftrennen kann, **dadurch gekennzeichnet, dass** der Schaltblock (310, 410) den mindestens einen Testblock (320, 420) mit einem Bezugspotential (28.1, 28.2) kurzschließen kann.

2. Sensoreinheit nach Anspruch 1, **dadurch gekennzeichnet, dass** der Schaltblock (10, 110, 210, 310, 410) mindestens einen Testanschlusskontakt (26), welcher im Normalbetrieb der Sensoreinheit (1, 101, 201, 301, 401) nicht erforderlich ist, vom Testblock (20, 220, 320, 420) trennen kann.

3. Sensoreinheit nach Anspruch 1 oder 2, **dadurch gekennzeichnet, dass** der Testblock (20, 120, 220, 320, 420) eine Testschaltung (22) und/oder eine Testlogik (24) und/oder den mindestens einen Testanschlusskontakt (26) umfasst, wobei die Testschaltung (22) über die mindestens eine Testverbindung (22.1, 122.1) mit dem Funktionsblock (3) und über mindestens eine Anschlussverbindung (22.2, 122.2) mit dem mindestens einen Testanschlusskontakt (26) verbunden ist, wobei die Testlogik (24) Ansteuersignale für die Testschaltung (22) zum Testen des Funktionsblocks (3) erzeugt, und wobei über den mindestens einen Testanschlusskontakt (26) Signale zum Testen des Funktionsblocks (3) eingebbar sind.

4. Sensoreinheit nach einem der Ansprüche 1 bis 3, **dadurch gekennzeichnet, dass** der Schaltblock (10, 110, 210, 310, 410) eine Schaltsteuerlogik (14, 114, 214, 314, 414) zum Ansteuern des mindestens einen Schaltelements (12.1, 12.2, 12.3) umfasst.

5. Sensoreinheit nach Anspruch 4, **dadurch gekennzeichnet, dass** die Schaltsteuerlogik (14, 114, 214, 314, 414) und die Testlogik (24) als gemeinsame Teststeuerlogik ausgeführt sind.

6. Sensoreinheit nach einem der Ansprüche 1 bis 5, **dadurch gekennzeichnet, dass** das mindestens eine Schaltelement (12.1, 12.2, 12.3) als Öffner (12.1, 12.2) zum Auftrennen einer korrespondierenden bestehenden Signalverbindung (122.1, 22.2) oder als Schließer (12.3) zum Herstellen einer Signalverbindung ausgeführt ist.

7. Sensoreinheit nach einem der Ansprüche 1 bis 6, **dadurch gekennzeichnet, dass** das mindestens eine Schaltelement (12.2) zum Auftrennen der mindestens einen Testverbindung (122.1) zwischen dem Testblock (120, 220, 420) und dem Funktionsblock (3) im direkten Umfeld des Funktionsblocks (3) angeordnet ist.

8. Sensoreinheit nach einem der Ansprüche 1 bis 7, **dadurch gekennzeichnet, dass** die Sensoreinheit (1, 101, 201, 301, 401) als ASIC ausgeführt ist.

9. Verfahren zur Bandendeprogrammierung einer Sensoreinheit, welche mindestens einen Funktionsblock (3) und mindestens einen Testblock (20, 120, 220, 320, 420) zum Testen des mindestens einen Funktionsblocks (3) aufweist, wobei am Ende des Fertigungsprozesses mindestens eine Testverbindung (122.1) zwischen dem Testblock (120, 220, 420) und dem Funktionsblock (3) aufgetrennt wird, **dadurch gekennzeichnet, dass** am Ende des Fertigungsprozesses der mindestens eine Testblock (320, 420) mit einem Bezugspotential (28.1, 28.2) kurzgeschlossen wird.

10. Verfahren nach Anspruch 9, **dadurch gekennzeichnet, dass** am Ende des Fertigungsprozesses ein Testanschlusskontakt (26), welcher im Normalbetrieb der Sensoreinheit (1, 101, 201, 301, 401) nicht erforderlich ist, vom Testblock (20, 220, 320, 420) getrennt wird.

## Claims

1. Sensor unit having at least one functional block (3) and at least one test block (20, 120, 220, 320, 420) for testing the at least one functional block (3) and a switching block (10, 110, 210, 310, 410) having at least one switching element (12.1, 12.2, 12.3) which can disconnect at least one test connection (122.1) between the test block (120, 220, 420) and the functional block (3), **characterized in that** the switching block (310, 410) can short-circuit the at least one test block (320, 420) with a reference potential (28.1, 28.2).

2. Sensor unit according to Claim 1, **characterized in that** the switching block (10, 110, 210, 310, 410) can disconnect at least one test connection contact (26), which is not required during normal operation of the sensor unit (1, 101, 201, 301, 401), from the test block (20, 220, 320, 420).

3. Sensor unit according to Claim 1 or 2, **characterized in that** the test block (20, 120, 220, 320, 420) comprises a test circuit (22) and/or a test logic unit (24) and/or the at least one test connection contact (26), the test circuit (22) being connected to the functional block (3) via the at least one test connection (22.1, 122.1) and being connected to the at least one test connection contact (26) via at least one connection (22.2, 122.2), the test logic unit (24) generating control signals for the test circuit (22) for testing the functional block (3), and signals for testing the functional block (3) being able to be input via the at least one test connection contact (26).

4. Sensor unit according to one of Claims 1 to 3, **characterized in that** the switching block (10, 110, 210, 310, 410) comprises a switching control logic unit (14, 114, 214, 314, 414) for controlling the at least one switching element (12.1, 12.2, 12.3).

5. Sensor unit according to Claim 4, **characterized in that** the switching control logic unit (14, 114, 214, 314, 414) and the test logic unit (24) are in the form of a common test control logic unit.

6. Sensor unit according to one of Claims 1 to 5, **characterized in that** the at least one switching element (12.1, 12.2, 12.3) is in the form of a normally closed contact (12.1, 12.2) for disconnecting a corresponding existing signal connection (122.1, 22.2) or is in the form of a normally open contact (12.3) for establishing a signal connection.

7. Sensor unit according to one of Claims 1 to 6, **characterized in that** the at least one switching element (12.2) for disconnecting the at least one test connection (122.1) between the test block (120, 220, 420) and the functional block (3) is arranged in the direct environment of the functional block (3).

8. Sensor unit according to one of Claims 1 to 7, **characterized in that** the sensor unit (1, 101, 201, 301, 401) is in the form of an ASIC.

9. Method for the end-of-line programming of a sensor unit having at least one functional block (3) and at least one test block (20, 120, 220, 320, 420) for testing the at least one functional block (3), at least one test connection (122.1) between the test block (120, 220, 420) and the functional block (3) being disconnected at the end of the production process, **characterized in that** the at least one test block (320, 420) is short-circuited with a reference potential (28.1, 28.2) at the end of the production process.

10. Method according to Claim 9, **characterized in that** a test connection contact (26), which is not required during normal operation of the sensor unit (1, 101, 201, 301, 401), is disconnected from the test block (20, 220, 320, 420) at the end of the production process.

## Revendications

1. Module de capteur comportant au moins un bloc fonctionnel (3) et au moins un bloc de test (20, 120, 220, 320, 420) destiné à tester l'au moins un bloc fonctionnel (3) et un bloc de commutation (10, 110, 210, 310, 410) comportant au moins un élément de commutation (12.1, 12.2, 12.3) qui peut déconnecter au moins une liaison de test (122.1) entre le bloc de test (120, 220, 420) et le bloc fonctionnel (3), **caractérisé en ce que** le bloc de commutation (310, 410) peut court-circuiter l'au moins un bloc de test (320, 420) avec un potentiel de référence (28.1, 28.2).

2. Module de capteur selon la revendication 1, **caractérisé en ce que** le bloc de commutation (10, 110, 210, 310, 410) peut séparer du bloc de test (20, 120, 220, 320, 420) au moins un contact de connexion de test (26) qui n'est pas nécessaire lors du fonctionnement normal du module de capteur (1, 101, 201, 301, 401).

3. Module de capteur selon la revendication 1 ou 2, **caractérisé en ce que** le bloc de test (20, 120, 220, 320, 420) comprend un circuit de test (22) et/ou un système logique de test (24) et/ou l'au moins un contact de connexion de test (26), dans lequel le circuit de test (22) est relié par l'intermédiaire de l'au moins une liaison de test (22.1, 122.1) au bloc fonctionnel (3) et par l'intermédiaire de l'au moins une liaison de connexion (22.2, 122.2) à l'au moins un contact de connexion de test (26), dans lequel le système logique de test (24) génère des signaux de commande destinés au circuit de test (22) pour tester le bloc fonctionnel (3), et dans lequel des signaux destinés à tester le bloc fonctionnel (3) peuvent être délivrés par l'intermédiaire de l'au moins un contact de connexion de test (26).

4. Module de capteur selon l'une quelconque des revendications 1 à 3, **caractérisé en ce que** le bloc de commutation (10, 110, 210, 310, 410) comprend un système logique de commande de commutation (14, 114, 214, 314, 414) destiné à commander l'au moins un élément de commutation (12.1, 12.2, 12.3).

5. Module de capteur selon la revendication 4, **caractérisé en ce que** le système logique de commande de commutation (14, 114, 214, 314, 414) et le système logique de test (24) sont réalisés sous la forme d'un système logique de commande de test commun.

6. Module de capteur selon l'une quelconque des revendications 1 à 5, **caractérisé en ce que** l'au moins un élément de commutation (12.1, 12.2, 12.3) est réalisé sous la forme d'un contact à ouverture (12.1, 12.2) destiné à déconnecter une liaison de signal existante correspondante (122.1, 22.2) ou sous la forme d'un contact à fermeture (12.3) destiné à établir une liaison de signal.

7. Module de capteur selon l'une quelconque des revendications 1 à 6, **caractérisé en ce que** l'au moins un élément de commutation (12.2) destiné à déconnecter l'au moins une liaison de test (122.1) entre le bloc de test (120, 220, 420) et le bloc fonctionnel (3) est disposé dans l'environnement direct du bloc fonctionnel (3).

8. Module de capteur selon l'une quelconque des revendications 1 à 7, **caractérisé en ce que** le module de capteur (1, 101, 201, 301, 401) est réalisé sous la forme d'un ASIC.

9. Procédé de programmation de fin de bande d'un module de capteur qui comporte au moins un bloc fonctionnel (3) et au moins un bloc de test (20, 120, 220, 320, 420) destiné à tester l'au moins un bloc fonctionnel (3), dans lequel, à la fin du processus de production, au moins une liaison de test (122.1) entre le bloc de test (120, 220, 420) et le bloc fonctionnel (3) est déconnectée, **caractérisé en ce que**, à la fin du processus de production, l'au moins un bloc de test (320, 420) est court-circuité à un potentiel de référence (28.1, 28.2).

10. Procédé selon la revendication 9, **caractérisé en ce que**, à la fin du processus de fabrication, un contact de connexion de test (26) qui n'est pas nécessaire lors du fonctionnement normal du module de capteur (1, 101, 201, 301, 401) est séparé du bloc de test (20, 120, 220, 320, 420).
